# EUROPEAN PATENT SPECIFICATION

(11) **EP 3 863 045 B1**
(45) Date of publication and mention of the grant of the patent: **21.05.2025**
(21) Application number: 20155372.4
(22) Date of filing: 04.02.2020
(51) Int. Cl.: H01L 23/373, H01L 23/498, H01L 23/538, H01L 25/07, H01L 23/00, H01L 25/16

(54) **POWER SEMICONDUCTOR MODULE ARRANGEMENT AND METHOD FOR PRODUCING THE SAME**
LEISTUNGSHALBLEITERMODULANORDNUNG UND VERFAHREN ZUR HERSTELLUNG DAVON
AGENCEMENT DE MODULE SEMI-CONDUCTEUR DE PUISSANCE ET SON PROCÉDÉ DE FABRICATION

(43) Date of publication of application: 11.08.2021
(73) Proprietor: Infineon Technologies AG, 85579 Neubiberg (DE)
(72) Inventor: MICHALSKI, Sebastian, 59557 Lippstadt (DE); SCHNIETZ, Mark, 59558 Lippstadt (DE)
(74) Representative: Westphal, Mussgnug & Partner, Patentanwälte mbB

(56) References cited:
- DE-T5- 112014 005 415
- JP-A- 2009 231 685
- US-A1- 2016 141 214
- US-B1- 9 508 658

## Description

### TECHNICAL FIELD

The instant disclosure relates to a power semiconductor module and a method for producing the same.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrates. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. The controllable semiconductor devices are usually mounted onto the semiconductor substrate by soldering or sintering techniques. An electronic board or metal sheet may be arranged in or on the same housing as the at least one substrate. The electronic board or metal sheet may form a lid of the housing, for example, or may be arranged on or below a lid of the housing on the inside or the outside of the housing. Electrical connections may be formed between the at least one semiconductor substrate and the electronic board or metal sheet. Such electrical connections should form a stable electrical connection between the at least one substrate and the electronic board or metal sheet.

Document DE 11 2014 005415 T5 discloses a power module comprising: - a base region with a surface on which an electrode region is formed; - a conductor region which is arranged so that it faces the base region; and a connecting region which is connected to the electrode region and a surface of the conductor region, the surface of the conductor region facing the one surface of the electrode region, the conductor region has an opening, opposite ends of the connection area being connected to the conductor area across the opening, and a part of the connection area at a position corresponding to the opening is connected to the electrode region, the connection region being a wire or a ribbon.

Document US 9 508 658 B1 discloses an apparatus having a package, a wall and a lid. The package may be configured to mount a plurality of chips. Two of the chips may generate a plurality of signals in a millimeter-wave frequency range. A metal is exposed at a surface of the package between the two chips. The metal is generally connected to an electrical ground. The wall may be formed on the metal and between the two chips. The wall generally has a plurality of arches that (i) are conductive, (ii) are wire bonded to the metal and (iii) attenuate an electromagnetic coupling between the two chips at the millimeter-wave frequency. The lid may be configured to enclose the chips to form a millimeter-wave cavity.

There is a need for a power semiconductor module arrangement comprising at least one semiconductor substrate and an electronic board or metal sheet, and having stable electrical connections between the at least one semiconductor substrate and the electronic board or metal sheet such that its risk of failure is low and its lifetime is long.

### SUMMARY

A power semiconductor module arrangement includes a semiconductor substrate arranged in a housing, an electronic board or metal sheet arranged in the housing distant from the semiconductor substrate, wherein the electronic board or metal sheet is arranged in parallel to the semiconductor substrate, and at least one electrical connection, configured to electrically couple the electronic board or metal sheet to the semiconductor substrate or to one of the elements mounted thereon, wherein each of the at least one electrical connection comprises a first end and a second end, and an intermediate section extending between the first end and the second end, and wherein the first end and the second end of each electrical connection are mechanically coupled to the electronic board or metal sheet, and a middle section of the intermediate section is mechanically coupled to the semiconductor substrate or to one of the elements mounted thereon. The electronic board or metal sheet forms a cover of the housing.

A method for producing a power semiconductor module arrangement includes mounting at least one electrical connection onto an electronic board or metal sheet by connecting a first end and a second end of the electrical connection to a first side of the electronic board or metal sheet, arranging the electronic board or metal sheet with the electrical connection mounted thereon in parallel to a semiconductor substrate such that the first side of the electronic board or metal sheet faces the semiconductor substrate, the semiconductor substrate having one or more elements mounted thereon, and connecting a middle section of an intermediate section of the electrical connection to the semiconductor substrate or to one of the elements mounted thereon, wherein the intermediate section extends between the first end and the second end of the electrical connection. The electronic board or metal sheet is arranged to form a cover of the housing.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a conventional power semiconductor module arrangement.
Figure 2 is a cross-sectional view of a power semiconductor module arrangement according to one example.
Figure 3 is a cross-sectional view of a power semiconductor module arrangement according to another example.
Figure 4, including Figures 4A to 4C, illustrates a method for producing a power semiconductor module arrangement according to one example.
Figure 5 illustrates an electronic board or metal sheet with an electrical connection formed thereon.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element", etc. are not to be understood as enumerative. Instead, such designations serve solely to address different "elements". That is, e.g., the existence of a "third element" does not require the existence of a "first element" and a "second element". Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

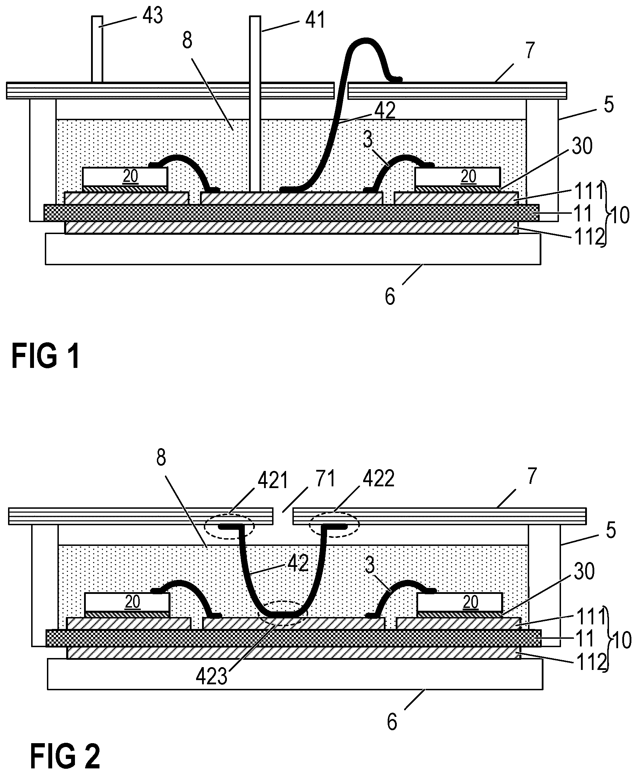

Referring to Figure 1, a cross-sectional view of a power semiconductor module arrangement is schematically illustrated. The power semiconductor module arrangement includes a semiconductor substrate 10. The semiconductor substrate 10 includes a dielectric insulation layer 11, a first (structured) metallization layer 111 attached to the dielectric insulation layer 11, and a second (structured) metallization layer 112 attached to the dielectric insulation layer 11. The dielectric insulation layer 11 is disposed between the first and the second metallization layer 111, 112. It is, however, also possible that the semiconductor substrate 10 only comprises a first metallization layer 111, while the second metallization layer 112 is omitted.

Each of the first and second metallization layers 111, 112 may consist of or include one of the following materials: copper; a copper alloy; aluminum; an aluminum alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., Si₂O, Al₂O₃, AlN, or BN and may have a diameter of between about 1µm and about 50µm. According to one example, an integrated semiconductor substrate is embedded in an AlSiC/magnesium base plate. The substrate 10 may also be a conventional printed circuit board (PCB) having a non-ceramic dielectric insulation layer 11. For instance, a non-ceramic dielectric insulation layer 11 may consist of or include a cured resin.

The semiconductor substrate 10 is arranged in a housing 5. In the arrangement illustrated in Figure 1, the semiconductor substrate 10 forms a ground surface of the housing 5, while the housing 5 itself solely comprises sidewalls. This is, however, only an example. It is also possible that the housing 5 further comprises a ground surface and/or a cover or lid and that the semiconductor substrate 10 is arranged inside the housing 5.

One or more semiconductor bodies 20 may be arranged on the semiconductor substrate 10. Each of the semiconductor bodies 20 arranged on the at least one semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), and/or any other suitable semiconductor element. The one or more semiconductor bodies 20 may form a semiconductor arrangement on the semiconductor substrate 10. In Figure 1, only two semiconductor bodies 20 are exemplarily illustrated.

The second metallization layer 112 of the semiconductor substrate 10 in Figure 1 is a continuous layer. The first metallization layer 111 is a structured layer in the arrangement illustrated in Figure 1. "Structured layer" means that the first metallization layer 111 is not a continuous layer, but includes recesses between different sections of the layer. Such recesses are schematically illustrated in Figure 1. The first metallization layer 111 in this arrangement includes three different sections. Different semiconductor bodies 20 may be mounted on the same or to different sections of the first metallization layer 111. Different sections of the first metallization layer may have no electrical connection or may be electrically connected to one or more other sections using first electrical connections 3 such as, e.g., bonding wires, bonding ribbons, ultrasonic welding terminals or joints, or soldered clip connections. First electrical connections 3 may also include connection plates or conductor rails, for example, to name just a few examples. The one or more semiconductor bodies 20 may be electrically and mechanically connected to the semiconductor substrate 10 by an electrically conductive connection layer 30. Such an electrically conductive connection layer 30 may be a solder layer, a layer of an electrically conductive adhesive, or a layer of a sintered metal powder, e.g., silver, for example.

The power semiconductor module arrangement illustrated in Figure 1 further includes first terminal elements 41. The first terminal elements 41 are electrically connected to the first metallization layer 111 and provide an electrical connection between the semiconductor substrate 10 and the outside of the housing 5. The first terminal elements 41 may be electrically connected to the first metallization layer 111 with a first end, while a second end of the first terminal elements 41 protrudes out of the housing 5. The first terminal elements 41 may be electrically contacted from the outside at their second end.

For example, the second ends of the first terminal elements 41 may be mechanically and electrically connected to an electronic board, e.g., a printed circuit board (PCB) having a dielectric insulation layer, or to a metal sheet 7. A metal sheet could be electrically coupled to a certain electrical potential, for example. For instance, a non-ceramic dielectric insulation layer may consist of or include a cured resin. The electronic board or metal sheet 7 forms a cover of the housing and may comprise through holes. The first terminal elements 41 may be inserted into the through holes of the electronic board or metal sheet 7. An electronic board 7 may comprise conducting tracks (not specifically illustrated) arranged on the dielectric insulation layer and a terminal element 41 may be electrically coupled to one or more other first terminal elements 41 by means of one or more such conducting tracks of the electronic board 7. A metal sheet generally is also electrically conducting. In this way, an electrical connection may be provided between different sections of the first metallization layer 111, between different semiconductor bodies 20, and/or between any other components that are arranged on the semiconductor substrate 10. The first terminal elements 41 may be soldered to the electronic board or metal sheet 7, for example, to provide for a permanent and solid connection. This, however, is only an example.

Alternatively or additionally, the power semiconductor module arrangement may comprise second terminal elements 43. Such second terminal elements 43 may be electrically and mechanically connected to the electronic board or metal sheet 7 with a first end, while a second end of the second terminal elements 43 protrudes from the electronic board or metal sheet 7. Second terminal elements 43 allow to electrically contact the power semiconductor module arrangement from outside the housing 5. However, contrary to the first terminal elements 41, the second terminal elements do not extend through the electronic board or metal sheet 7 towards the semiconductor substrate 10. The second terminal elements 43 terminate on the electronic board or metal sheet 7. A second terminal element 43 may be electrically coupled to a conductor track of the electronic board or to the metal sheet 7, for example. An electrical connection between the respective conductor track or the metal sheet and the semiconductor substrate 10 may be established by means of one or more of the first terminal elements or by one or more second electrical connections 42, as will be described in the following.

The power semiconductor module arrangement alternatively or additionally may include second electrical connections 42. Such second electrical connections 42 may also provide an electrical connection between the semiconductor substrate 10 and the electronic board or metal sheet 7, and may or may not protrude through the electronic board or metal sheet 7 to the outside of the housing 5. The second electrical connection 42 in Figure 1 may comprise a bonding wire or bonding ribbon, for example. A first end of a bonding wire or ribbon is soldered (or welded) to the semiconductor substrate 10, and a second end of a bonding wire or ribbon is soldered (or welded) to the electronic board or metal sheet 7. In order to form such a connection 42 that does not protrude through the electronic board or metal sheet 7 to the outside of the housing 5, a spring contact may be used, for example, which is pre-assembled and soldered (or welded) to the semiconductor substrate 10 afterwards. If the second electrical connection 42 protrudes through the electronic board or metal sheet 7 to the outside of the housing 5, the second electrical connection 42 may extend through an opening in the electronic board or metal sheet 7 to the outside of the housing 5, for example.

The housing 5 may be at least partly filled with a sealing resin 8. The sealing resin 8 may include a (filled) epoxy resin, silicone gel or other resin materials, for example. The sealing resin 8 is configured to seal the components of the power semiconductor module such as the semiconductor substrate 10, in particular the metal patterns formed by the first metallization layer 111, the semiconductor bodies 20, the first electrical connections 3, the first terminal elements 41, and the second electrical connections 42, to provide for insulation and protection of the devices. For example, the sealing resin 8 may protect the components from certain environmental conditions and from mechanical damage. The sealing resin 8 may at least partly fill the interior of the housing 5, thereby covering the components and electrical connections that are arranged on the semiconductor substrate 10. The first terminal elements 41 and the second electrical connections 42 may be partly embedded in the sealing resin 8. At least the second ends of the first terminal elements 41 and of the second electrical connections 42, however, are not covered by the sealing resin 8 and protrude from the sealing resin 8 to the electronic board or metal sheet 7.

The power semiconductor module may further include a base plate 6. The semiconductor substrate 10 may be connected to the base plate 6 via a connection layer (not illustrated). Such a connection layer may be a solder layer, a layer of an adhesive, or a layer of a sintered metal powder, e.g., silver, for example.

Figure 1 schematically illustrates a power semiconductor arrangement with a base plate 6. However, it is also possible that the base plate 6 be omitted. In such cases, the semiconductor substrate 10 may form a ground surface of the housing 5, for example. The semiconductor substrate 10, instead of on a base plate 6, may be arranged on a heat sink, for example. Generally, if the power semiconductor module arrangement comprises a base plate 6, the base plate 6 may also further be arranged on a heat sink (heat sink not specifically illustrated) such that the base plate 6 is arranged between the heat sink and the semiconductor substrate 10, for example. In some power semiconductor module arrangements, more than one semiconductor substrate 10 is arranged on a single base plate 6. Irrespective of the number of semiconductor substrates 10 that are mounted on the base plate 6, the base plate 6 may form a ground surface of the housing 5, for example. Semiconductor bodies 20 may be arranged on one or more of a plurality of semiconductor substrates 10.

When producing the power semiconductor module of Figure 1, generally the one or more semiconductor substrates 10 are assembled first. That is, the first metallization layer 111 and, optionally, the second metallization layer 112 are formed on the dielectric insulation layer 11, and one or more semiconductor bodies 20 are arranged on the semiconductor substrate 10. Assembly of the one or more semiconductor substrates 10 further comprises forming the first electrical connections 3 on the semiconductor substrates 10. Any other elements of a power semiconductor module arrangement may be mounted onto the semiconductor substrate 10 as well during the assembly process. Once the at least one semiconductor substrate 10 is fully assembled, it may be arranged in a housing 5. An electronic board having conductor tracks formed thereon or a metal sheet 7 may then be provided. During or shortly before mounting the electronic board or metal sheet 7 onto the housing 5, the second electrical connections 42 may be formed. That is, a first end of a second electrical connection 42 (e.g., bonding wire or ribbon) may be mounted onto one of the at least one semiconductor substrate 10. The electronic board or metal sheet 7 may then be arranged close to the housing 5, but not yet fully covering the housing 5, in order to be able to couple the second end of the second electrical connection 42 to the electronic board or metal sheet 7. Once all necessary second electrical connections 42 have been formed, the electronic board or metal sheet 7 may be mounted and fixed onto the housing 5, thereby forming a cover of the housing 5, for example.

Forming the second electrical connections 42, in particular forming a connection between the second ends and the electronic board or metal sheet 7 may be challenging. The electronic board or metal sheet 7 needs to be firmly held in place and prevented from vibrating. There is a risk that second electrical connections 42 are defective or that second electrical connections 42 are torn off during the process of mounting the electronic board or metal sheet 7 onto the housing 5. Therefore, second electrical connections 42 that electrically couple a semiconductor substrate 10 to an electronic board or metal sheet 7 in the described manner are often designed redundantly. That is, two or more second electrical connections 42 may be used to form a single connection. In this way, the number of defects may be reduced and the reliability of the power semiconductor module arrangement may be increased. On the other hand, however, the overall costs for the power semiconductor module increase, as more electrical connections are required. This results in an increase of material usage, as well as in increased space requirements.

Now referring to Figure 2, a power semiconductor module arrangement according to one example is schematically illustrated. The power semiconductor module arrangement essentially corresponds to the arrangement illustrated in Figure 1. First and second terminal elements 41, 43, however, are not specifically illustrated in Figure 2. The at least one second electrical connection 42 differs from the second electrical connection 42 as discussed with respect to Figure 1 above. In Figure 2, one second electrical connection 42 is exemplarily illustrated. However, a power semiconductor module arrangement may comprise a plurality of second electrical connections 42 in order to electrically couple various sections of the first metallization layer 111 and various conducting paths of the electronic board 7, or various sections of the first metallization layer 111 and the metal sheet 7 to each other.

The second electrical connection 42 illustrated in Figure 2 comprises a first end 421 that is mechanically coupled to the electronic board or metal sheet 7, and a second end 422 that is mechanically coupled to the electronic board or metal sheet 7 distant to the first end 421. The first end 421 may be electrically coupled to a first conductor track of an electronic board 7, for example. The second end 422 may be electrically coupled to the first or to a second conductor track of the electronic board 7, for example. The different first and the second conductor tracks, however, may be coupled to the same electrical potential. The second electrical connection 42 further comprises an intermediate section extending between the first end 421 and the second end 422. The intermediate section is mechanically coupled to the semiconductor substrate 10. In particular, a middle section 423 of the intermediate section may be mechanically coupled to the semiconductor substrate 10. A middle section 423 of the intermediate section is a section that is arranged essentially centrally between the first end 421 and the second end 422. That is, a distance from the middle section 423 to the first end 421 essentially equals a distance between the middle section 423 and the second end 422.

The intermediate section of the second electrical connection 42 may form an arc, bridge or loop between the first end 421 and the second end 422. That is, the intermediate section extends from the first end 421 and the second end 422 towards the semiconductor substrate 10, when the power semiconductor module arrangement is fully assembled. The middle section 423 of the intermediate section may form the topmost point (or undermost point) of the arc, bridge or loop. That is, the middle section 423 may form that part of the intermediate section that is arranged the farthest away from the electronic board or metal sheet 7 and the closest to the semiconductor substrate 10 when the power semiconductor module arrangement is fully assembled. The arc, bridge or loop formed by the intermediate section may have an offset that may give way when connecting the middle section 423 to the semiconductor substrate 10. In this way, the risk of breakage or damage to the second electrical connection 42, in particular the risk of unintentionally tearing off the first end 421 and the second end 422 from the electronic board or metal sheet 7, may be greatly reduced. The arc, bridge or loop formed by the intermediate section may have a rounded form, as is schematically illustrated in Figure 2. However, generally it is also possible that the arc, bridge or loop has an angular form. That is, the intermediate section may have comparably sharp corners, in particular near the middle section 423. Generally, the intermediate section may have any suitable form.

The second electrical connection 42 illustrated in Figure 2 and described above is a very stable connection. The second electrical connection 42 comprises two points of contact connecting the second electrical connection 42 to the electronic board or metal sheet 7, and a further point of contact connecting the second electrical connection 42 to the semiconductor substrate 10. This makes a redundant design superfluous. That is, there is no need to provide two identical second electrical connections 42 for the same electrical interconnection between the semiconductor substrate 10 and the electronic board or metal sheet 7. The overall costs as well as the space requirements and therefore the size of the power semiconductor module arrangement of the example illustrated in Figure 2, therefore, are reduced as compared to the arrangement as illustrated in Figure 1, which generally requires a redundant design in order to reduce the risk of failures.

The second electrical connection 42 may comprise a bonding wire or a bonding ribbon. Bonding wires generally have a round or rounded (e.g., oval) cross section, while bonding ribbons generally have an angular (e.g., square or rectangular) cross section. Bonding wires may have diameters of between 10µm and 50µm (thin bonding wires), or between 50µm and 600µm (thick bonding wires), for example. Any other diameters, however, are also possible. The diameter of a bonding wire may depend on the material that is used to form the bonding wire, for example. The diameter of a bonding wire may further depend on the application the power semiconductor module arrangement is to be used in and the current range of the specific application, for example. Dimensions of bonding ribbons may be in the range of 60 x 10µm (width x thickness) up to 3000 x 400µm, for example. Any other dimensions, however, are also possible.

The at least one second electrical connection 42 may comprise at least one of Al (aluminum), AlMg (magnesium alloyed aluminum), Cu (copper), and Au (gold), for example. That is, aluminum, aluminum alloyed, copper or gold bonding wires or ribbons may be used to form the second electrical connections 42, for example. According to one example, the at least one second electrical connection 42 comprises an aluminum cladded copper wire.

A mechanical connection between the first and second ends 421, 422 and the electronic board or metal sheet 7, respectively, may be a bond connection or a welded connection, for example. That is, the connections may be formed by means of a bonding process or a welding process, for example. According to one example, an ultrasonic bonding or welding process is used in order to form the connections between the first and second ends 421, 422 and the electronic board or metal sheet 7. The same applies for the mechanical connection between the middle section 423 of the intermediate section of the second electrical connection 42 and the semiconductor substrate 10. This connection between the middle section 423 and the semiconductor substrate 10 may also be a bond connection or a welded connection, for example.

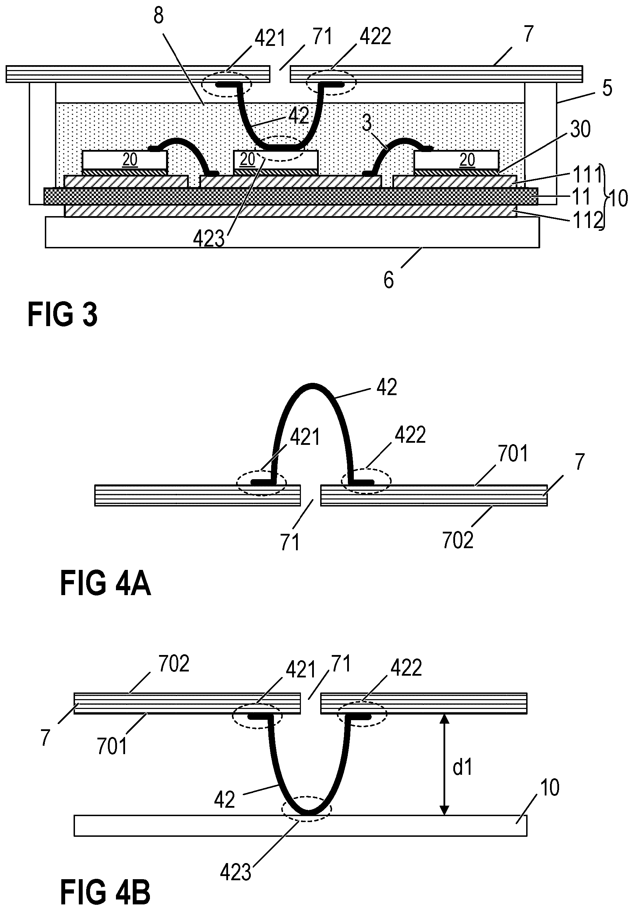

In the example illustrated in Figure 2, the middle section 423 is mechanically and electrically coupled to the semiconductor substrate 10. However, it is also possible that the middle section 423 is mechanically and electronically coupled to other components of the power semiconductor module arrangement. As is illustrated in the example of Figure 3, it is also possible to mechanically and electrically couple the middle section 423 to one of the semiconductor bodies 20, for example. The middle section 423 alternatively may be mechanically and electrically coupled to any other suitable components of the power semiconductor module arrangement. It is possible to combine the different options within one and the same power semiconductor module arrangement. That is, if the power semiconductor module arrangement comprises more than one second electrical connections 42, a first group of second electrical connections 42 may be mechanically end electrically coupled to the semiconductor substrate 10, while another group of second electrical connections 42 may be mechanically and electrically coupled to a semiconductor body 20 or any other component of the power semiconductor module arrangement. Each group of second electrical connections 42 may comprise one or more of a plurality of second electrical connections 42.

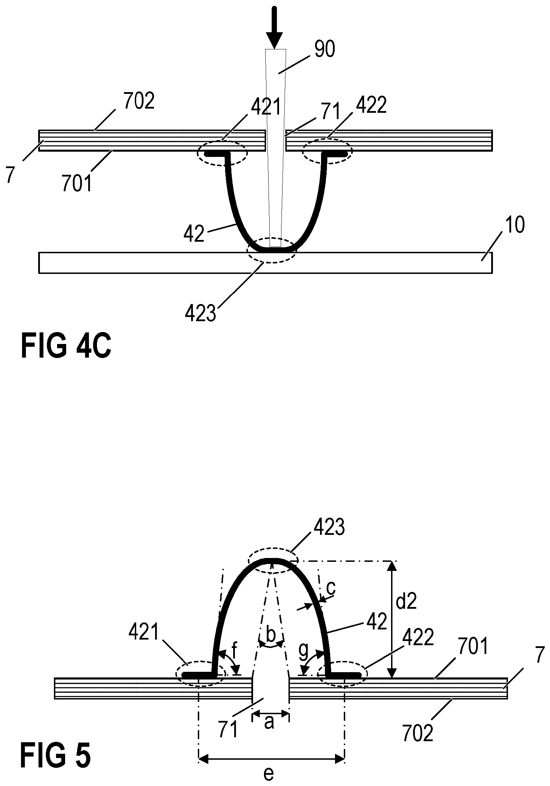

Now referring to Figure 4, a method for forming an electrical connection according to one example is exemplarily illustrated. In a first step (Figure 4A), a second electrical connection 42 may be mounted onto an electronic board or metal sheet 7. That is, a first end 421 and a second end 422 of an electrical connection 42 may be mechanically (and electrically) coupled to the electronic board or metal sheet 7. The connections between the first and second ends 421, 422 and the electronic board or metal sheet 7 may be formed by means of a bonding, a welding, or an ultrasonic bonding or welding process, for example. Such processes are generally known and will not be described in further detail herein. Mounting the second electrical connection 42 onto the electronic board or metal sheet 7 may be similar to arranging a conventional bonding wire or bonding ribbon on a printed circuit board, a metal sheet or a semiconductor substrate, for example. In this way, a very stable connection may be formed between the second electrical connection 42 and the electronic board or metal sheet 7. The second electrical connection 42 may be arranged on a first side of the electronic board or metal sheet 7. During the mounting process (Figure 4A), the first side of the electronic board or metal sheet 7 may be a top side of the electronic board or metal sheet 7. That is, the first side may be a side which faces the bonding or welding tool, for example.

Now referring to Figure 4B, the electronic board or metal sheet 7 with the second electrical connection 42 mounted thereon may be arranged above a semiconductor substrate 10. That is, the electronic board or metal sheet 7 may be arranged distant from and in parallel to a semiconductor substrate 10. In Figures 4B and 4C, the semiconductor substrate 10 is only schematically illustrated. In this simplified representation, the metallization layers 111, 112 as well as any semiconductor bodies 20 or first electrical connections 3 or any other elements are omitted for convenience only. When the electronic board or metal sheet 7 is arranged above the semiconductor substrate 10, the semiconductor substrate 10 may already be fully assembled. That is, all semiconductor bodies 20 and first electrical connections 3 that are necessary for the specific application may already be arranged on the semiconductor substrate 10. When arranging the electronic board or metal sheet 7 above the semiconductor substrate 10, the first side of the electronic board or metal sheet 7 may face the semiconductor substrate 10. That is, the first side of the electronic board or metal sheet 7 may face a first side of the semiconductor substrate 10, wherein the first side of the semiconductor substrate 10 is a side on which at least one semiconductor body 20 is arranged (see, e.g., Figures 2 and 3).

A distance d1 between the electronic board or metal sheet 7 and the semiconductor substrate 10 (or between the electronic board or metal sheet 7 and the semiconductor body 20 or any other component, if the middle section 423 is mechanically coupled to one of the semiconductor bodies 20 or any of the other components), may equal or be slightly less than a height d2 of the arc, bridge or loop formed by the intermediate section of the second electrical connection 42. The height d2 of the arc, bridge or loop may equal a distance between the middle section 423 and the electronic board or metal sheet 7 (see Figure 5). That is, when arranging the electronic board or metal sheet 7 with the second electrical connection 42 mounted thereon above the semiconductor substrate 10, the middle section 423 of the second electronic connection 42 loosely contacts the semiconductor substrate 10, the semiconductor body 20, or any other component of the power semiconductor module arrangement.

The electronic board or metal sheet 7 comprises a though hole 71. The first end 421 of the second electronic connection 42 is arranged on a first side of the through hole 71, and the second end 422 of the second electronic connection 42 is arranged on a second side of the through hole 71, wherein the second side is opposite to the first side. In this way, the intermediate section of the second electronic connection 42 extends over the through hole 71. A connection tool 90 (e.g., bonding or welding tool) may be inserted through the through hole 71 and may press the middle section 423 onto the semiconductor substrate 10, semiconductor body 20 or other component, in order to form a connection between the middle section 423 and the semiconductor substrate 10, semiconductor body 20 or other component (Figure 4C). While pressing the middle section 423 onto the semiconductor substrate 10, semiconductor body 20 or other component, heat may be applied. It is also possible to perform an ultrasonic process, wherein the connection tool 90 vibrates at a certain frequency. The through hole 71 allows an easy access of the connection tool 90 towards the middle section 423. In this way, a very stable connection may be formed between the second electrical connection 42 and the semiconductor substrate 10, semiconductor body 20 or other component in an easy and convenient way even if the electronic board or metal sheet 7 is already arranged in its final mounted position. That is, the electronic board or metal sheet 7 remains in its position after forming the connections between the middle sections 423 and the semiconductor substrate 10, semiconductor body 20, or other component.

If more than one second electrical connection 42 is arranged on the electronic board or metal sheet 7, the electronic board or metal sheet 7 may comprise a plurality of through holes 71. The number of through holes 71 may be equal to or greater than the number of second electrical connections 42. That is, each second electrical connection 42 may be arranged on the electronic board or metal sheet 7 such that its middle section 423 extends over a different one of the through holes 71. This allows to mechanically couple each of the second electrical connections 42 to the semiconductor substrate 10, semiconductor body 20, or other component after arranging the electronic board or metal sheet 7 above the semiconductor substrate 10. If the number of through holes 71 is greater than the number of second electrical connections 42, any additional through holes 71 may serve different purposes, for example. For example, lead frames 41 may extend through any additional through holes 71. This, however, is optional.

A method for producing a power semiconductor module arrangement may comprise assembling the semiconductor substrate 10 before arranging the electronic board or metal sheet 7 above the semiconductor substrate 10. The step of assembling the semiconductor substrate 10 has already been discussed exemplarily above. A method for producing a power semiconductor module arrangement may further comprise arranging the semiconductor substrate 10 in a housing 5. A housing 5 is not illustrated in the example of Figure 4. The semiconductor substrate 10 may be fully assembled when it is arranged in the housing 5, for example. The electronic board or metal sheet 7 may then be arranged in or on the housing 5. For example, the electronic board or metal sheet 7 may be arranged on the sidewalls of the housing 5. A height of the sidewalls in this case may define the distance d1 between the electronic board or metal sheet 7 and the semiconductor substrate 10. The electronic board or metal sheet 7 may be fixed to the sidewalls of the housing 5 in any suitable way (e.g., insert, gluing, screwing or clamping). It is also possible that the sidewalls of the housing 5 comprise projections on the inside of the housing 5. The electronic board or metal sheet 7 may be arranged inside the housing 5, resting on such projections, for example. In this way, the electronic board or metal sheet 7 may be precisely aligned with respect to the layout of the semiconductor substrate 10. An additional adhesion or clamping in order to fix the electronic board or metal sheet 7 in its position may not even be necessary in many cases. The mechanical (and electrical) connections between the middle sections 423 of the at least one second electrical connection 42 and the semiconductor substrate 10, semiconductor body 20 or other component may then be easily formed by inserting the connection tool 90 through the respective through holes 71. According to one example, the electronic board or metal sheet 7 forms a cover of the housing 5. According to another example (not specifically illustrated), an additional cover may be mounted on the sidewalls such that the electronic board or metal sheet 7 is arranged inside the housing 5 and is not directly accessible from the outside of the housing.

Generally, second electrical connections 42, as have been described with respect to Figures 2 and 3 above, allow the usage of the power semiconductor module arrangement for applications having a voltage class of even above 3.3kV. The risk of failures is reduced as compared to conventional arrangements.

Now referring to Figure 5, a second electrical connection 42 that is mounted on an electronic board or metal sheet 7 is illustrated in greater detail. As has been explained above, the second electrical connection 42 comprises a first end 421 that is coupled to the electronic board or metal sheet 7. The second electrical connection 42 further comprises a second end 422 that is coupled to the electronic board or metal sheet 7. The first and second ends 421, 422 are arranged on opposite sides of a though hole 71 on the same side of the electronic board or metal sheet 7. A distance e between the first end 421 and the second end 422 may be larger than a width a of the through hole 71 in the same direction. That is, the first and second ends 421, 422 may not directly adjoin the though hole 71. Instead, the first end and the second end 421, 422 each are arranged at a certain distance from the outer diameter of the through hole 71. This distance may depend on the dimensions of the second electrical connection 42 as well as on the distance between the electronic board or metal sheet 7 and the semiconductor substrate 10, semiconductor body 20 or other component in the fully assembled power semiconductor module arrangement.

The intermediate section of the second electronic connection 42 extends from the electronic board or metal sheet 7 and forms an arc, bridge or loop that extends from the first end 421 over the through hole 71 to the second end 422. The middle section 423 is arranged directly above the through hole 71 to be accessible by a connection tool 90. The dimensions a of the through hole 71 generally depend on the size of the connection tool 90 that is used to form the connection between the middle section 423 and the semiconductor substrate 10, semiconductor body 20, or other component. The through hole 71 is large enough in order to allow the connection tool 90 to easily access the middle section 423. Even further, if an ultrasonic bonding or welding process is used to form the connection between the middle section 423 and the semiconductor substrate 10, semiconductor body or other component, the dimensions a of the through hole 71 may further allow vibrations of the connection tool 90. That is, even when vibrating during the connection process, the connection tool 90 may not touch the electronic board or metal sheet 7. Therefore, no vibrations may be transferred from the connection tool 90 to the electronic board or metal sheet 7.

An angle f between the first end 421 and the intermediate section generally depends on the height d2 of the arc, bridge or loop as well as on the dimensions a of the through hole 71. The same applies for an angle g between the second end 422 and the intermediate section. The dimension c (e.g., diameter) of the electrical connection 42 (e.g., bonding wire or bonding ribbon) has already been discussed above. The height d2 of the arc may depend on the distance e between the first end 421 and the second end 422 as well as on the angles f, g between the first and second ends 421, 422 and the intermediate section. Generally, the shape of the arc, bridge or loop formed by the intermediate section of the second electrical connection 42 may vary depending on the size and dimensions of the power semiconductor module arrangement and its components in order to be able to give way (elasticity) when connecting the middle section 423 to the semiconductor substrate 10, semiconductor body 20 or other component to prevent damage to the previously formed contacts between the first end 421 and the second end 422 and the electronic board or metal sheet 7.

## Claims

1. A power semiconductor module arrangement comprising:
a semiconductor substrate (10) arranged in a housing (5), the semiconductor substrate (10) having one or more elements mounted thereon;
an electronic board or metal sheet (7) arranged in the housing (5) distant from the semiconductor substrate (10), wherein the electronic board or metal sheet (7) is arranged in parallel to the semiconductor substrate (10); and
at least one electrical connection (42), configured to electrically couple the electronic board or metal sheet (7) to the semiconductor substrate (10) or to one of the elements mounted thereon, wherein each of the at least one electrical connection (42) comprises a first end (421) and a second end (422), and an intermediate section extending between the first end (421) and the second end (422), and wherein the first end (421) and the second end (422) of each electrical connection (42) are mechanically coupled to the electronic board or metal sheet (7), and a middle section (423) of the intermediate section is mechanically coupled to the semiconductor substrate (10) or to one of the elements mounted thereon, **characterized in that** the electronic board or metal sheet (7) forms a cover of the housing (5).

2. The power semiconductor module arrangement of claim 1, wherein the intermediate section of each electrical connection (42) forms an arc, bridge or loop between the first end (421) and the second end (422) of the respective electrical connection (42).

3. The power semiconductor module arrangement of claim 2, wherein the middle section (423) is arranged centrally between the first end (421) and the second end (422) at the highest point of the arc, bridge or loop, constituting a section of the second electrical connection (42) that is arranged the farthest away from the electronic board or metal sheet (7).

4. The power semiconductor module arrangement of any of claims 1 to 3, wherein the electronic board or metal sheet (7) comprises at least one through hole (71), and wherein, for each of the at least one electrical connection (42),
the first end (421) is arranged on a first side of one of the at least one through hole (71);
the second end (422) is arranged on a second side of the respective through hole (71), the second side being opposite to the first side, and
the intermediate section extends over the through hole (71).

5. The power semiconductor module arrangement of any of claims 1 to 4, wherein each of the at least one electrical connection (42) comprises a bonding wire or a bonding ribbon.

6. The power semiconductor module arrangement of any of claims 1 to 5, wherein each of the at least one electrical connection (42) comprises at least one of Al, AlMg, Cu, and Au or an aluminum cladded copper wire.

7. The power semiconductor module arrangement of any of claims 1 to 6, wherein a mechanical connection between the first end (421) and the electronic board or metal sheet (7), between the second end (422) and the electronic board or metal sheet (7), and between the middle section (423) and the semiconductor substrate (10) or the element mounted thereon is a bond connection, or a welded joint.

8. The power semiconductor module arrangement of any of the preceding claims, wherein the at least one element comprises at least one semiconductor body (20) that is mounted on a first surface of the semiconductor substrate (10).

9. The power semiconductor module arrangement of claim 8, wherein the at least one electrical connection (42) is arranged on a first surface of the electronic board or metal sheet (7), and wherein the first surface of the electronic board or metal sheet (7) faces the first surface of the semiconductor substrate (10).

10. A method for producing a power semiconductor module arrangement, the method comprising:
mounting at least one electrical connection (42) onto an electronic board or metal sheet (7) by connecting a first end (421) and a second end (422) of the electrical connection (42) to a first side of the electronic board or metal sheet (7);
arranging the electronic board or metal sheet (7) with the electrical connection (42) mounted thereon in parallel to a semiconductor substrate (10) such that the first side of the electronic board or metal sheet (7) faces the semiconductor substrate (10), the semiconductor substrate (10) having one or more elements mounted thereon; and
connecting a middle section (423) of an intermediate section of the electrical connection (42) to the semiconductor substrate (10) or to one of the elements mounted thereon, wherein the intermediate section extends between the first end (421) and the second end (422) of the electrical connection (42), wherein
the electronic board or metal sheet (7) is arranged to form a cover of the housing (5).

11. The method of claim 10, wherein connecting the middle section (423) of the intermediate section of the electrical connection (42) to the semiconductor substrate (10) or to one of the elements mounted thereon comprises inserting a connection tool (90) through a through hole (71) of the electronic board or metal sheet (7) and pressing the middle section (423) on the semiconductor substrate (10) or to one of the elements mounted thereon.

12. The method of claim 10 or 11, further comprising, before arranging the electronic board or metal sheet (7) with the electrical connection (42) mounted thereon in parallel to a semiconductor substrate (10), arranging the semiconductor substrate (10) in a housing (5).

13. The method of claim 12, wherein arranging the electronic board or metal sheet (7) with the electrical connection (42) mounted thereon in parallel to a semiconductor substrate (10) comprises arranging the electronic board or metal sheet (7) in or on the housing (5).

## Patentansprüche

1. Leistungshalbleitermodulanordnung, umfassend:
ein Halbleitersubstrat (10), das in einem Gehäuse (5) angeordnet ist, wobei auf dem Halbleitersubstrat (10) ein oder mehrere Elemente montiert sind;
eine Elektronikplatine oder ein Metallblech (7), das in dem Gehäuse (5) in einem Abstand zu dem Halbleitersubstrat (10) angeordnet ist, wobei die Elektronikplatine oder das Metallblech (7) parallel zu dem Halbleitersubstrat (10) angeordnet ist; und
mindestens eine elektrische Verbindung (42), die dazu ausgelegt ist, die Elektronikplatine oder das Metallblech (7) elektrisch mit dem Halbleitersubstrat (10) oder einem der darauf montierten Elemente zu koppeln, wobei jede der mindestens einen elektrischen Verbindung (42) ein erstes Ende (421) und ein zweites Ende (422) und einen zwischen dem ersten Ende (421) und dem zweiten Ende (422) verlaufenden Zwischenabschnitt umfasst, und wobei das erste Ende (421) und das zweite Ende (422) jeder elektrischen Verbindung (42) mechanisch mit der Elektronikplatine oder dem Metallblech (7) gekoppelt sind und ein Mittelabschnitt (423) des Zwischenabschnitts mechanisch mit dem Halbleitersubstrat (10) oder einem der darauf montierten Elemente gekoppelt ist, **dadurch gekennzeichnet, dass** die Elektronikplatine oder das Metallblech (7) einen Deckel des Gehäuses (5) bildet.

2. Leistungshalbleitermodulanordnung nach Anspruch 1, wobei der Zwischenabschnitt jeder elektrischen Verbindung (42) einen Bogen, eine Brücke oder eine Schleife zwischen dem ersten Ende (421) und dem zweiten Ende (422) der jeweiligen elektrischen Verbindung (42) bildet.

3. Leistungshalbleitermodulanordnung nach Anspruch 2, wobei der Mittelabschnitt (423) mittig zwischen dem ersten Ende (421) und dem zweiten Ende (422) am höchsten Punkt des Bogens, der Brücke oder der Schleife angeordnet ist und einen Abschnitt der zweiten elektrischen Verbindung (42) darstellt, der am weitesten von der Elektronikplatine oder dem Metallblech (7) entfernt angeordnet ist.

4. Leistungshalbleitermodulanordnung nach einem der Ansprüche 1 bis 3, wobei die Elektronikplatine oder das Metallblech (7) mindestens ein Durchgangsloch (71) umfasst und wobei für jede der mindestens einen elektrischen Verbindung (42)
das erste Ende (421) auf einer ersten Seite eines des mindestens einen Durchgangslochs (71) angeordnet ist; das zweite Ende (422) auf einer zweiten Seite des jeweiligen Durchgangslochs (71) angeordnet ist, wobei die zweite Seite der ersten Seite gegenüberliegt; und
der Zwischenabschnitt über das Durchgangsloch (71) hinweg verläuft.

5. Leistungshalbleitermodulanordnung nach einem der Ansprüche 1 bis 4, wobei jede der mindestens einen elektrischen Verbindung (42) einen Bonddraht oder ein Bondband umfasst.

6. Leistungshalbleitermodulanordnung nach einem der Ansprüche 1 bis 5, wobei jede der mindestens einen elektrischen Verbindung (42) mindestens eines von Al, AlMg, Cu und Au oder einen aluminiumumkaschierten Kupferdraht umfasst.

7. Leistungshalbleitermodulanordnung nach einem der Ansprüche 1 bis 6, wobei eine mechanische Verbindung zwischen dem ersten Ende (421) und der Elektronikplatine oder dem Metallblech (7), zwischen dem zweiten Ende (422) und der Elektronikplatine oder dem Metallblech (7) und zwischen dem Mittelabschnitt (423) und dem Halbleitersubstrat (10) oder dem darauf montierten Element eine Bondverbindung oder eine Schweißverbindung ist.

8. Leistungshalbleitermodulanordnung nach einem der vorhergehenden Ansprüche, wobei das mindestens eine Element mindestens einen Halbleiterkörper (20) umfasst, der auf einer ersten Oberfläche des Halbleitersubstrats (10) montiert ist.

9. Leistungshalbleitermodulanordnung nach Anspruch 8, wobei die mindestens eine elektrische Verbindung (42) auf einer ersten Oberfläche der Elektronikplatine oder des Metallblechs (7) angeordnet ist und wobei die erste Oberfläche der Elektronikplatine oder des Metallblechs (7) der ersten Oberfläche des Halbleitersubstrats (10) zugewandt ist.

10. Verfahren zur Herstellung einer Halbeitermodulanordnung, wobei das Verfahren Folgendes umfasst:
Montieren mindestens einer elektrischen Verbindung (42) auf einer Elektronikplatine oder einem Metallblech (7) durch Verbinden eines ersten Endes (421) und eines zweiten Endes (422) der elektrischen Verbindung (42) mit einer ersten Seite der Elektronikplatine oder des Metallblechs (7);
Anordnen der Elektronikplatine oder des Metallblechs (7) mit der darauf montierten elektrischen Verbindung (42) parallel zu einem Halbleitersubstrat (10) so, dass die erste Seite der Elektronikplatine oder des Metallblechs (7) dem Halbleitersubstrat (10) zugewandt ist, wobei das Halbleitersubstrat (10) ein oder mehrere darauf montierte Elemente aufweist; und
Verbinden eines mittleren Abschnitts (423) eines Zwischenabschnitts der elektrischen Verbindung (42) mit dem Halbleitersubstrat (10) oder mit einem der darauf montierten Elemente, wobei sich der Zwischenabschnitt zwischen dem ersten Ende (421) und dem zweiten Ende (422) der elektrischen Verbindung (42) erstreckt, wobei die Elektronikplatine oder das Blech (7) als Deckel des Gehäuses (5) angeordnet ist.

11. Verfahren nach Anspruch 10, wobei das Verbinden des mittleren Abschnitts (423) des Zwischenabschnitts der elektrischen Verbindung (42) mit dem Halbleitersubstrat (10) oder mit einem der darauf montierten Elemente das Einführen eines Verbindungswerkzeugs (90) durch ein Durchgangsloch (71) der Elektronikplatine oder des Metallblechs (7) und das Pressen des mittleren Abschnitts (423) auf das Halbleitersubstrat (10) oder auf eines der darauf montierten Elemente umfasst.

12. Verfahren nach Anspruch 10 oder 11, ferner umfassend, vor dem Anordnen der Elektronikplatine oder des Metallblechs (7) mit der darauf montierten elektrischen Verbindung (42) parallel zu einem Halbleitersubstrat (10) das Anordnen des Halbleitersubstrats (10) in einem Gehäuse (5).

13. Verfahren nach Anspruch 12, wobei das Anordnen der Elektronikplatine oder des Metallblechs (7) mit der darauf montierten elektrischen Verbindung (42) parallel zu einem Halbleitersubstrat (10) das Anordnen der Elektronikplatine oder des Metallblechs (7) in oder auf dem Gehäuse (5) umfasst.

## Revendications

1. Un agencement de module à semiconducteur de puissance comprenant :
un substrat (10) à semiconducteur disposé dans un boîtier (5), un ou plusieurs éléments étant montés sur le substrat (10) à semiconducteur ;
une plaquette électronique ou une feuille (7) métallique disposée dans le boîtier (5) à distance du substrat (10) à semiconducteur, la plaquette électronique ou la feuille (7) métallique étant disposée parallèlement au substrat (10) à semiconducteur ; et
au moins une connexion (42) électrique, configurée pour connecter électriquement la plaquette électronique ou la feuille (7) métallique au substrat (10) à semiconducteur ou à l'un des éléments, qui y sont montés, dans lequel chacune de la au moins une connexion (42) électrique comprend une première extrémité (421) et une deuxième extrémité (422), et une partie intermédiaire s'étendant entre la première extrémité (421) et la deuxième extrémité (422), et dans lequel la première extrémité (421) et la deuxième extrémité (422) de chaque connexion (42) électrique sont assemblées mécaniquement à la plaquette électronique ou à la feuille (7) métallique, et une partie (423) médiane de la partie intermédiaire est assemblée mécaniquement au substrat (10) à semiconducteur ou à l'un des éléments, qui y sont montés, **caractérisé en ce que** la plaquette électronique ou la feuille (7) métallique forme un couvercle du boîtier (5).

2. L'agencement de module à semiconducteur de puissance de la revendication 1, dans lequel la partie intermédiaire de chaque connexion (42) électrique forme un arc, un pont ou une boucle entre la première extrémité (421) et la deuxième extrémité (422) de la connexion (42) électrique respective.

3. L'agencement de module à semiconducteur de puissance de la revendication 2, dans lequel la partie (423) médiane est disposée d'une manière centrale entre la première extrémité (421) et la deuxième extrémité (422) au point le plus haut de l'arc, du pont ou de la boucle, en constituant une partie de la deuxième connexion (42) électrique, qui est disposée le plus loin de la plaquette électronique ou de la feuille (7) métallique.

4. L'agencement de module à semiconducteur de puissance de l'une quelconque des revendications 1 à 3, dans lequel la plaquette électronique ou la feuille (7) métallique comprend au moins un trou (71) traversant, et dans lequel pour chacune de la au moins une connexion (42) électrique,
la première extrémité (421) est disposée d'un premier côté de l'un du au moins un trou (71) traversant ;
la deuxième extrémité (422) est disposée d'un deuxième côté du trou (71) traversant respectif, le deuxième côté étant opposé au premier côté, et
la partie intermédiaire s'étend sur le trou (71) traversant.

5. L'agencement de module à semiconducteur de puissance de l'une quelconque des revendications 1 à 4, dans lequel chacune de la au moins une connexion (42) électrique comprend un fil de liaison ou un ruban de liaison.

6. L'agencement de module à semiconducteur de puissance de l'une quelconque des revendications 1 à 5, dans lequel chacune de la au moins une connexion (42) électrique comprend au moins l'un d'un fil d'Al, d'AlMg, de Cu et d'Au ou d'un fil de cuivre plaqué d'aluminium.

7. L'agencement de module à semiconducteur de puissance de l'une quelconque des revendications 1 à 6, dans lequel un assemblage mécanique entre la première extrémité (421) et la plaquette électronique ou la feuille (7) métallique, entre la deuxième extrémité (422) et la plaquette électronique ou la feuille (7) métallique, et entre la partie (423) médiane et le substrat (10) à semiconducteur ou l'élément, qui y est monté, est un assemblage par liaison ou un joint soudé.

8. L'agencement de module à semiconducteur de puissance de l'une quelconque des revendications précédentes, dans lequel le au moins un élément comprend au moins un corps (20) à semiconducteur, qui est monté sur une première surface du substrat (10) à semiconducteur.

9. L'agencement de module à semiconducteur de puissance de la revendication 8, dans lequel la au moins une connexion (42) électrique est disposée sur une première surface de la plaquette électronique ou de la feuille (7) métallique, et dans lequel la première surface de la plaquette électronique ou de la feuille (7) métallique fait face à la première surface du substrat (10) à semiconducteur.

10. Un procédé de production d'un agencement de module à semiconducteur de puissance, le procédé comprenant :
monter au moins une connexion (42) électrique sur une plaquette électronique ou une feuille (7) métallique en connectant une première extrémité (421) et une deuxième extrémité (422) de la connexion (42) électrique à une première face de la plaquette électronique ou de la feuille (7) métallique ;
disposer la plaquette électronique ou la feuille (7) métallique avec la connexion (42) électrique, qui y est montée, parallèlement à un substrat (10) à semiconducteur, de manière à ce que la première face de la plaquette électronique ou de la feuille (7) métallique fasse face au substrat (10) à semiconducteur, le substrat (10) à semiconducteur ayant un ou plusieurs éléments, qui y sont montés ; et
connecter une partie (423) médiane d'une partie intermédiaire de la connexion (42) électrique au substrat (10) à semiconducteur ou à l'un des éléments, qui y sont montés, dans lequel la partie intermédiaire s'étend entre la première extrémité (421) et la deuxième extrémité (422) de la connexion (42) électrique, dans lequel
la plaquette électronique ou la feuille (7) métallique est disposée pour former un couvercle du boîtier (5).

11. Le procédé de la revendication 10, dans lequel connecter la partie (423) médiane de la partie intermédiaire de la connexion (42) électrique au substrat (10) à semiconducteur ou à l'un des éléments, qui y sont montés, comprend insérer un outil (90) de connexion dans un trou (71) traversant de la plaquette électronique ou de la feuille (7) métallique et presser la partie (423) médiane sur le substrat (10) à semiconducteur ou sur l'un des éléments, qui y sont montés.

12. Le procédé de la revendication 10 ou 11, comprenant en outre, avant de disposer la plaquette électronique ou la feuille (7) métallique avec la connexion (42) électrique, qui y est montée, parallèlement au substrat (10) à semiconducteur, mettre le substrat (10) à semiconducteur dans un boîtier (5).

13. Le procédé de la revendication 12, dans lequel disposer la plaquette électronique ou la feuille (7) métallique ayant la connexion (42) électrique, qui y est montée, parallèlement à un substrat (10) à semiconducteur, comprend mettre la plaquette électronique ou la feuille (7) métallique dans ou sur le boîtier (5).
